# EUROPEAN PATENT SPECIFICATION

(11) **EP 3 406 118 B1**
(45) Date of publication and mention of the grant of the patent: **05.08.2020**
(21) Application number: 16738908.9
(22) Date of filing: 09.06.2016
(51) Int. Cl.: H05K 7/14

(54) **SYSTEM AND METHOD FOR MODULAR DATA CENTER**
SYSTEM UND VERFAHREN FÜR MODULARES DATENZENTRUM
SYSTÈME ET PROCÉDÉ POUR CENTRE MODULAIRE DE TRAITEMENT DE L'INFORMATION

(30) Priority: 21.01.2016 US 201615002661
(43) Date of publication of application: 28.11.2018
(73) Proprietor: Vertiv Corporation, Columbus, OH 43085 (US)
(72) Inventor: MATORIC, Ivan, 10000 Zagreb (HR); UZELAC, Goran, 10410 Velika Gorica (HR); RANCIC, Denis, 10430 Samobor (HR); CRNOGORAC, Mislav, 10000 Zagreb (HR)
(74) Representative: Bryn-Jacobsen, Caelia
(86) International application number: PCT/US2016/036683
(87) International publication number: WO 2017/127130

(56) References cited:
- WO-A2-2014/039524
- US-A1- 2008 277 391
- US-B1- 8 320 125

## Description

### FIELD

The present disclosure relates to data center systems and methods for constructing data centers, and more particularly to a modular, prefabricated data center structure that makes use of a plurality of carriage assemblies associated with each one of a plurality of unit structures, and wherein the carriage assemblies allow each unit structure to be wheeled into position along a pair of elevated support rails when assembling a data center building to thus expedite the assembly of the data center building.

### BACKGROUND

The statements in this section merely provide background information related to the present disclosure and may not constitute prior art.

As data center needs increase world-wide, there has been increasing interest in finding more cost effective ways to set up and construct data centers. Additional concerns are consistent quality of the data center components and the time required to construct the data center. These concerns are especially relevant when constructing data centers in countries other than the United States. Traditionally data centers have been constructed in "stick building" fashion completely at the selected data center site. This involves bringing all the raw materials out to the data center site, using large numbers of construction workers such as electrical contractors, welders, building construction workers and other skilled tradesmen to construct the data center structure from the raw materials shipped to the site. As will be appreciated, this construction approach can be quite costly. Maintaining quality of the finished data center structure can sometimes be challenging, typically requiring numerous inspections by various individuals as the construction process is on-going. Construction delays may be encountered when specific subcomponents or raw materials being used to construct the data center are not received at the building site according to the planned construction timetable. The need to separately ship independent building components (steel, cable trays, wall panels, etc.) to the site can also contribute significantly to the overall high cost of constructing a data center. Seasonal weather changes and delays brought on by inclement weather can also result in a lengthy and costly construction timeline for a data center structure.

Additional concerns with data centers are the ability to easily and cost-effectively expand the data center as needs grow. With conventional data center structures that have been constructed using the "stick build" approach, expansion can sometimes be expensive and particularly time consuming.

Accordingly, there is strong interest in reducing the cost of a data center structure as well as the time needed for its construction. Significantly reducing the overall construction cost of a data center structure and the time required to get a new data center up and running may make it feasible to set up data centers in various parts of the world where the cost of constructing a data center with the conventional "stick build" approach would make the endeavor cost prohibitive.

WO 2014/039524 A2 discloses a data center including a floor that supports rack computing systems and walls that enclose a computing room. The computing room holds the rack computing systems. One of the walls is a movable wall. The movable wall translates relative to the other walls to increase or decrease the size of the computing room.

### SUMMARY

An invention is defined in the independent claims. The embodiments and/or examples of the following description which are not covered by the appended claims are considered as not being part of the present invention.

In one aspect the present disclosure relates to a modular data center system. The modular data center system may comprise a plurality of unit structures for channeling at least one of cold air or hot air from data center components located within the modular data center system when the modular data center system is fully assembled to form a modular data center building. A plurality of structural support columns support the plurality of unit structures above a floor surface at a desired height relative to the floor surface. A pair of elongated support rails are also included which are coupled perpendicularly to the plurality of structural support columns, at approximately the desired height, to form two parallel, horizontally spaced apart tracks. Each of the unit structures includes a plurality of carriage assemblies, with each of the carriage assemblies including a wheel. The wheel of each one of the carriage assemblies allows the unit structures to be rolled horizontally into a desired position on the pair of elongated support rails when constructing a modular data center building to expedite assembly of the modular data center building.

In another aspect the present disclosure relates to a modular data center system including a plurality of unit structures for channeling at least one of cold air or hot air from data center components located within the modular data center system when the modular data center system is fully assembled. The system may include a plurality of structural support columns for supporting the plurality of unit structures above a floor surface at a desired height relative to the floor surface. A pair of elongated support rails may be included. The elongated support rails may be coupled perpendicularly to the plurality of structural support columns at approximately the desired height to form two parallel, horizontally spaced apart tracks. Each unit structure may include a plurality of carriage assemblies. Each carriage assembly may include a wheel and is configured such that the wheels of the carriage assemblies are positioned adjacent each one of four corners of the unit structure. The wheels of the carriage assemblies enable the unit structures to be rolled horizontally into a desired position on the pair of elongated support rails when constructing a modular data center building.

In still another aspect the present disclosure relates to a method for forming a modular data center. The method may comprise providing a plurality of unit structures for channeling at least one of cold air or hot air from data center components located within the modular data center when the modular data center is fully assembled. The method may also comprise using a plurality of first structural support columns for supporting the plurality of unit structures above a floor surface at a desired height relative to the floor surface. A pair of elongated support rails may also be used which are coupled perpendicularly to the plurality of first structural support columns at approximately the desired height to form two parallel, horizontally spaced apart tracks. The method may also involve using a plurality of carriage assemblies, with each of the carriage assemblies including a wheel, to support each of the unit structures on the elongated support rails. The method may include using the wheels of the carriage assemblies to horizontally roll each of the unit structures along the elongated support rails into a desired position on the pair of elongated support rails when constructing the modular data center.

### BRIEF DESCRIPTION OF THE DRAWINGS

The drawings described herein are for illustration purposes only and are not intended to limit the scope of the present disclosure in any way. In the drawings:
Figure 1 is a perspective illustration of a plurality of modular, collapsible data center unit structures disposed adjacent one another to help form a data center, in accordance with one embodiment of the present disclosure;
Figure 2 is an enlarged perspective view of a portion of one of the data center unit structures of the present disclosure even more fully illustrating a plurality of foldable cable tray supports, along with one cable tray, that each unit structure incorporates;
Figure 2a is a perspective view of a portion of one form of pivoting mechanism that may be used to support the hangers, which involves the use of an elongated tubular support member which is able to rotate;
Figure 2b is an enlarged perspective view of the saddle-like strap shown in Figure 2a which may be used to help enable rotational movement of the elongated tubular support member shown in Figure 2a;
Figure 3 is a perspective view of one of the data center unit structures shown in Figure 1 but with the unit structure in its collapsed configuration for shipping;
Figure 4 is a perspective view of two data center unit structures in their collapsed configurations and positioned back-to-back, which forms a highly compact package suitable for placement in a standard shipping container;
Figure 5 is a high level side view of a portion of a data center in which two of the data center unit structures are shown forming an elongated row, and further illustrating a modular penthouse exhaust structure that resides above the data center unit structures to facilitate the exhaust of hot air from hot air isles formed between rows of equipment racks positioned underneath the unit structures;
Figure 6 is an enlarged view of just circled portion 6 in Figure 5;
Figure 6a is a perspective view of a portion of one end of the data center illustrating how hot air from a hot air isle may be exhausted through the modular penthouse exhaust structure;
Figure 7 is a perspective view of modular cooling unit that may be used with the data center unit structures to help form a modular data center;
Figure 8 shows a perspective view of one of the modular cooling units arranged adjacent the ends of a plurality of the data center unit structures;
Figure 9 is a high level top view illustrating the components of the modular cooling unit shown in Figure 7;
Figure 10 is a high level front view of the modular cooling unit of Figure 9;
Figure 11 is a high level side view of the cooling unit of Figure 9 in accordance with arrow 11 in Figure 10;
Figure 12 is a high level perspective view of just a filter unit of the modular cooling unit;
Figure 13 is a high level perspective view of just a fan unit of the modular cooling unit;
Figure 14 is a high level perspective view of just a cooling module media unit of the modular cooling unit;
Figure 15 is another high level perspective view of the modular cooling unit but with its outer wall structure removed, and further with the wall structure surrounding one of the fan units removed;
Figure 16 further illustrates components that may be included within each of the modular cooling units;
Figure 17 is a perspective view of one modular cooling unit located adjacent to a plurality of the data center unit structures illustrating how hot exhaust (i.e., return) air from one of the hot isles may be returned to the modular cooling unit;
Figure 18 is a high level overhead view of a portion of a data center illustrating a plurality of modular sections that together form a "power hall" for a data center, and which are located adjacent to a plurality of the data center unit structures;
Figure 19 illustrates a modular power supply unit for constructing the power hall shown in Figure 18;
Figure 20 illustrates a modular power cabinet unit for use in constructing the power hall shown in Figure 18;
Figure 21 shows a modular UPS unit for use in constructing the power hall shown in Figure 18;
Figure 22 shows a modular PDU unit for use in constructing the power hall shown in Figure 18;
Figure 23 is an overhead view of one exemplary layout for a data center that makes use of two halls separated by a modular office/storage area and a modular water treatment unit;
Figure 24 is a perspective view of another embodiment of the unit structure; and
Figure 25 is a perspective view of a portion of the unit structure of Figure 24 illustrating a centrally located cable tray.
Figure 26 is a perspective view of a portion of a modular data center system in which a plurality of unit structures can be rolled along horizontal support rails into a desired position when the data center is being constructed;
Figure 27a is a perspective view of a first one of the unit structures indicating that the carriage assemblies are arranged at the four corners thereof;
Figure 27b is a perspective view of a second one of the unit structures also indicating that the carriage assemblies are arranged at the four corners thereof;
Figure 28 is a cross sectional end view of one of the carriage assemblies, as indicated by circled areas 28 in Figures 27a and 27b;
Figure 29 is a top perspective view of a portion of one of the inverted U-shaped support rails and one of the carriage assemblies;
Figure 30 is bottom perspective view of the carriage assembly of Figure 29;
Figure 31 is a cross sectional end view of one of the carriage assemblies taken in accordance with section line 31-31 in Figure 29;
Figure 32 is a cross sectional side view of the carriage assembly of Figure 31 taken in accordance with section line 32-32 in Figure 31; and
Figure 33 is a perspective view of one of the carriage assemblies showing the wheel thereof positioned on one of the horizontal support rails and abutting the base plate.

### DETAILED DESCRIPTION

The following description is merely exemplary in nature and is not intended to limit the present disclosure, application, or uses. It should be understood that throughout the drawings, corresponding reference numerals indicate like or corresponding parts and features.

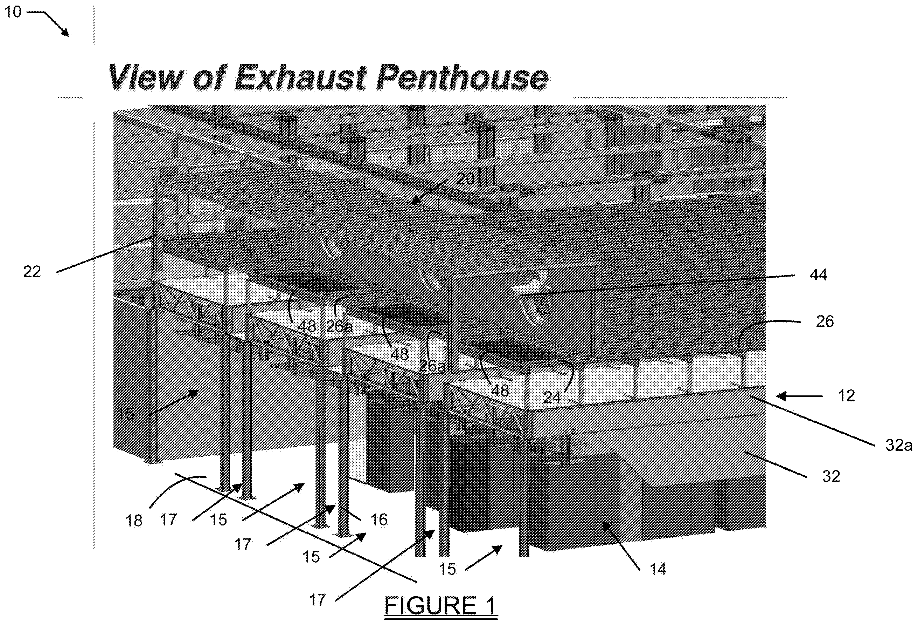

Referring to Figure 1 there is shown a portion of a modular data center facility 10 incorporating a plurality of modular, collapsible data center unit structures 12 (hereinafter simply "unit structures 12") for forming a rapidly deployable data center. Each of the unit structures 12 forms an elongated structure which may be used to channel both cold air from one or more air conditioning systems through a cold aisle 15 which separates parallel rows of equipment racks 14, as well to help channel hot air from a hot aisle. Each unit structure 12 is adapted to be supported by structural support columns 16 at a predetermined height above a floor 18 of the data center facility 10. Figure 1 illustrates a plurality of the unit structures 12 positioned in side-by-side fashion. Adjacent ones of the unit structures 12 are further spaced apart a predetermined distance. This spacing forms hot aisles 17 between adjacent ones of the unit structures 12.

With further reference to Figure 1, the modular data center facility 10 may also include one or more modular penthouse exhaust structures 20 for receiving hot air from the hot aisles 17 and exhausting the hot air from the modular data center facility 10. The modular penthouse exhaust structures 20 receive the hot air flow from the hot aisles 17 through openings 24 in ceiling panels 26 of the unit structures 12. This feature will be explained in greater detail in the following paragraphs. A plurality of bridging ceiling panels 26a are also used to bridge the spacing between adjacent ones of the unit structures 12, and thus ensure that hot air being drawn out from the hot aisles 17 is exhausted through the openings 24.

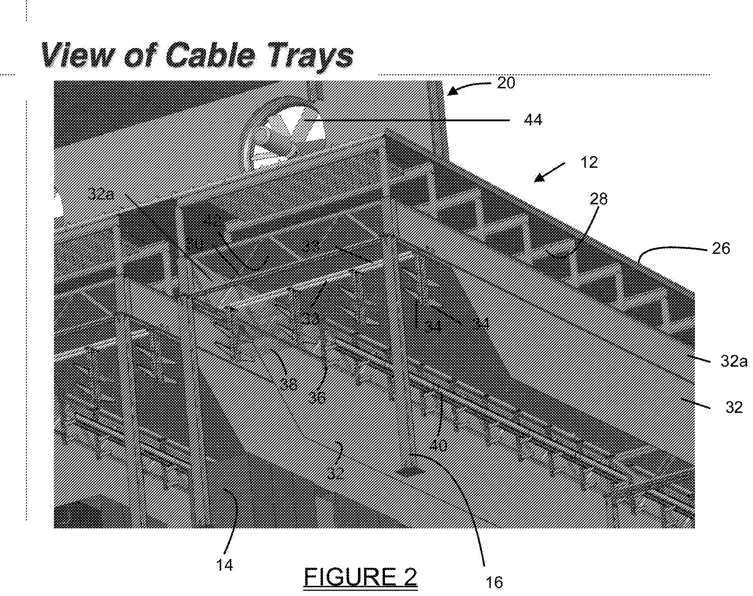

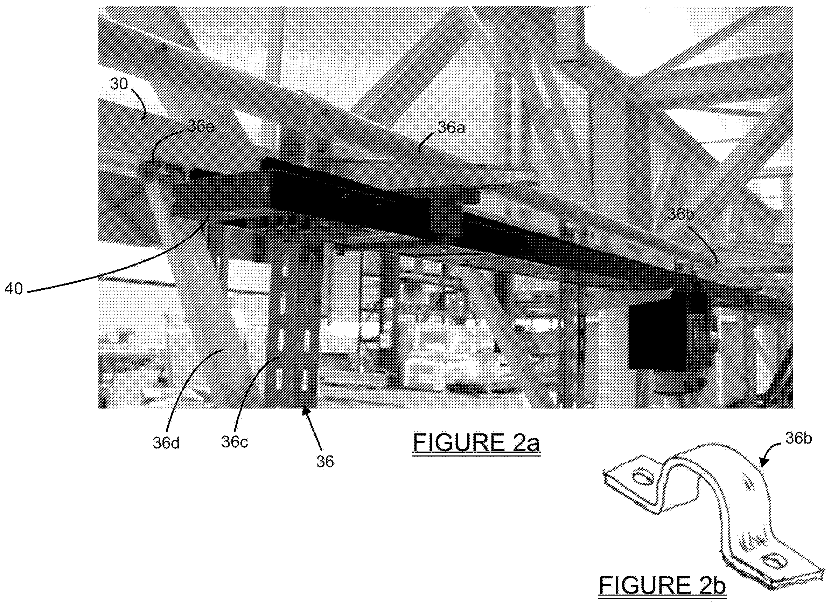

Referring to Figure 2, one of the unit structures 12 is shown in greater detail. In addition to the ceiling panel 26, each unit structure 12 has a frame structure 28 that supports a plurality of the ceiling panels 26 to form a roof-like structure. A perimeter frame structure 30 may be coupled to the structural support columns 16. The perimeter frame structure 30 may be used to support collapsible (i.e., foldable) panels 32 to help maintain cold air from air conditioning systems within the cold aisles 15 between adjacent rows of equipment racks 14. The perimeter frame structure 30 also may include a plurality of pivotally secured hangers 34 and 36 that are supported from the frame structure 30. Hangers 34 in this example are supported from separate cross members 33 and are able to pivot into the orientation shown in Figure 2 for use. Hangers 34 may have a plurality of cable trays 38 secured thereto and hangers 36 may likewise have a plurality of cable trays 40 secured thereto. Cable trays 38 and 40 may be used to support a variety of different types of cables such as network cables, power cables, etc., that need to be routed through the data center facility 10 to equipment components mounted in the rows of equipment racks 14. A roof panel 42 may also be secured to the perimeter frame structure 30. Roof panel 42 forms a partition which further helps to channel cold air from one or more air conditioning systems through the cold aisle 15 formed between adjacent rows of equipment racks 14.

With brief reference to Figure 2a, a portion of one of the hangers 36 is shown. The hanger 36 may be representative of, or identical, to the construction used for the hangers 34. The ability of the hanger 36 to pivot is achieved, in one example, by using a round, rigid, tubular, elongated support member 36a, which may be supported for rotational movement at its opposing ends by a saddle-like bracket 36b, where the saddle-like bracket 36b is fixedly secured to a portion of the perimeter frame structure 30 by suitable fasteners (not shown). The saddle like bracket 36b is also shown in Figure 2b. Of course any other suitable hinge or hinge-like structures could be implemented to enable pivoting motion of the hanger 36.

Figure 2a also shows that the hanger 36 may include a plurality of depending structural members 36c which may support the cable trays 40. The depending structural members 36c may be fixedly secured to the elongated support member 36a so as to be able to rotate with the elongated support member 36a, and thus be able to present the trays 40 in an operative position below the perimeter frame structure 30 or in a stowed orientation. One or more braces 36d may be used to brace the hanger 36 in its operative position. The braces 36d may each be secured at one end to the perimeter frame structure 30 by suitable brackets 36e that enable pivoting motion thereof, and at their opposite ends to the depending structural members 36c. This enables the braces 36d to be pivoted upwardly into stowed configurations once detached from the structural members 36c. Still, the braces 36d are able to be quickly and easily secured to the structural members 36c of the hanger 36, to brace the hanger 36 once the hanger 36 is lowered into its operative position. It will also be appreciated that the hangers 36, as well as the hangers 34, may be constructed from suitable structural supports and brackets to permit their easy removal from the perimeter frame structure 30, instead of a folding motion. Depending on how many cable trays 38 and 40 are employed, and the overall dimensions of the unit structure 12, it may be helpful or necessary to have the hangers 34 and or 36 supported by structure that is removable completely from the perimeter frame structure 30 when the unit structure is prepared for shipping.

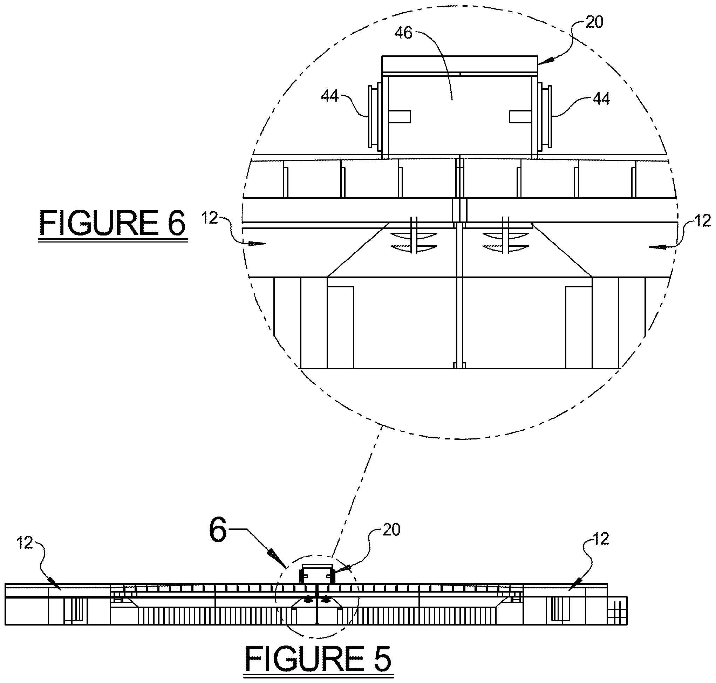

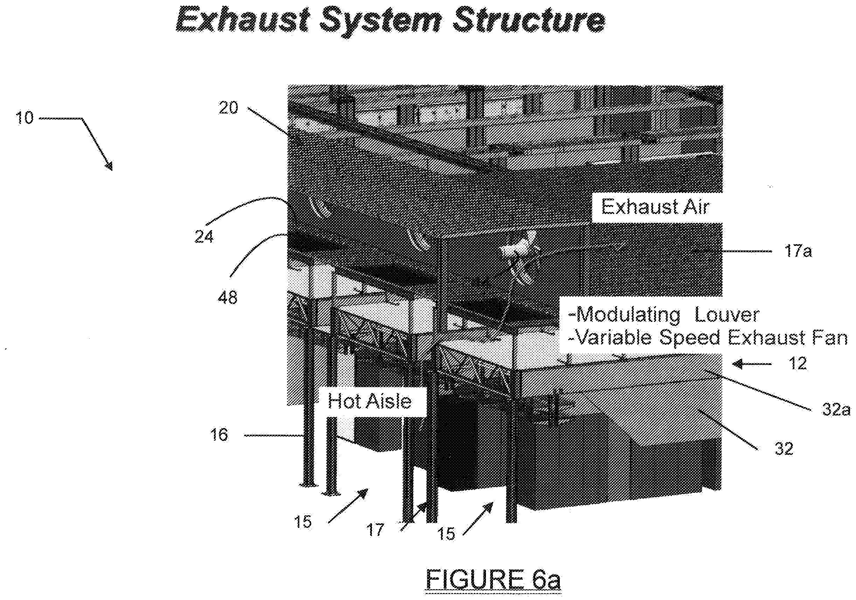

With reference to Figures 5, 6 and 6a, one of the modular penthouse exhaust structures 20 is shown from one end thereof. It will be appreciated that, in practice, a plurality of the modular penthouse exhaust structures 20 will be used to form an elongated channel 46 into which hot air 17a from the hot aisles 17 may be drawn into with the assistance of a plurality of opposing exhaust fans 44. In one embodiment each modular penthouse exhaust structure 20 may include a total of six exhaust fans 44 arranged as two opposing rows of three fans. With further reference to Figure 1, the openings 24 in the ceiling panels 26 may also have positioned therein modulated louver assemblies 48 that may be electronically modulated to tailor the flow of hot air from the hot aisles 17 that may be drawn into the penthouse exhaust structures 20. Suitable air flow and/or temperature control monitoring systems (not shown) may be provided for this purpose.

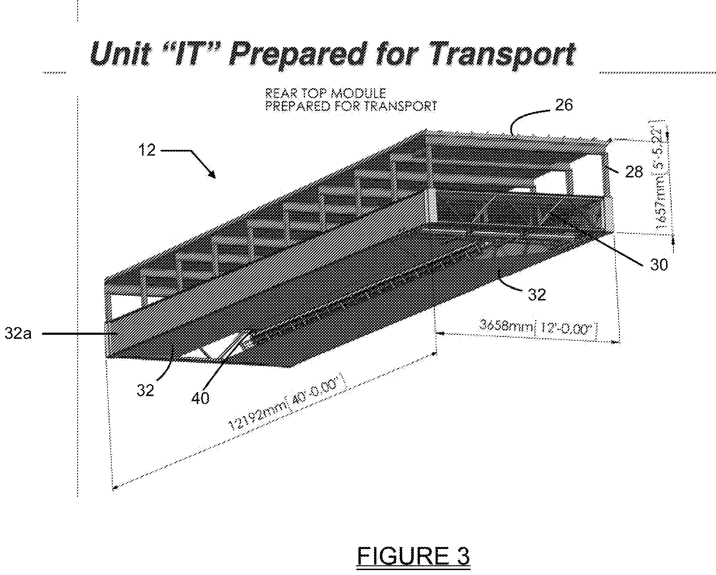

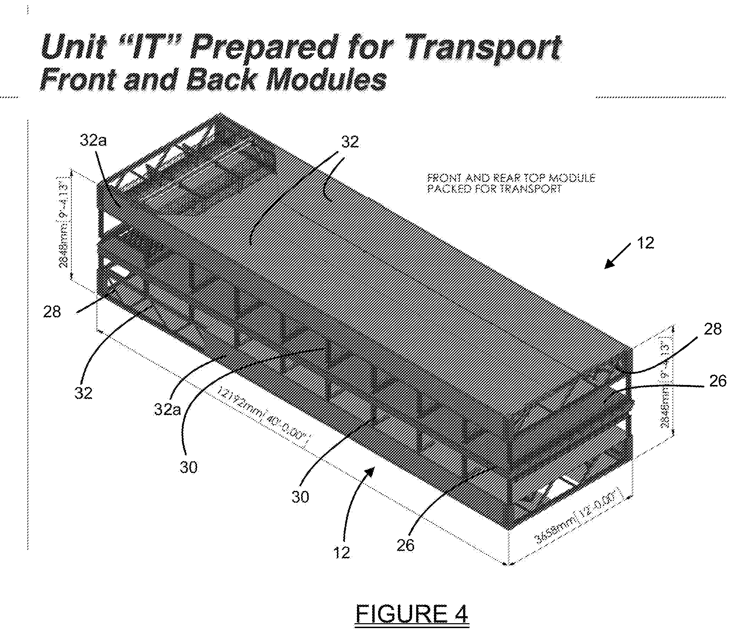

Referring to Figure 3, one of the unit structures 12 is shown in its collapsed configuration. The unit structure 12 has the hangers 34 and 36 pivoted into a stowed position where they are held such that they do not protrude below panel portions 32a of panels 32. Panels 32 are also pivoted such that they extend parallel to the ceiling panels 26. In the collapsed configuration the unit structure 12 forms an elongated, relatively narrow configuration with the hangers 34 and 36, as well as the cable trays 38 and 40, tucked up between the panel portions 32a. This configuration also forms a highly space efficient configuration from a shipping and packaging standpoint. Any suitable locking structure may be used in connection with the panels 32 to hold the panels 32 in their collapsed configuration, such as elongated structural beams (not shown) that may be physically connected to select portions of the panels 32 and the perimeter frame structure 30. Figure 4 illustrates a pair of the unit structures 12 in their collapsed configurations positioned back-to-back. Each of the unit structures 12, when in its collapsed configuration, may have dimensions of approximately 12192mm (40.0 feet) in overall length by 3658mm (12.0 feet) in width and 2848mm (5 feet and 5.22 inches) in height. The back-to-back positioned pair of unit structures 12 in Figure 4 may have overall dimensions of about 12192mm (40 feet) in length, 3658mm (12 feet) in width and 2848mm (9 feet and 4.13 inches) in overall height. The collapsed configuration enables a pair of the unit structures 12 to be efficiently packaged for shipping.

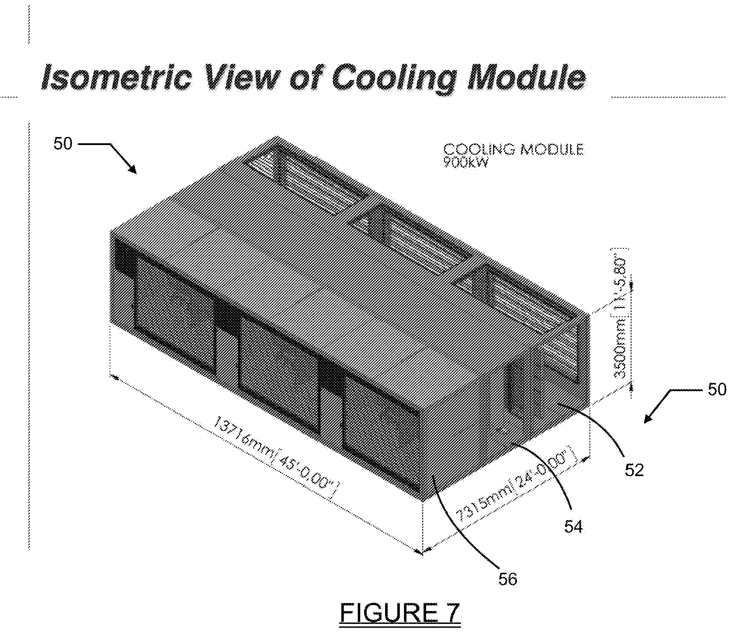

Figure 7 illustrates a modular cooling unit 50 that may be used to help form the modular data center facility 10 of Figure 1. It will be noted that the modular cooling unit 50 may have dimensions of about 13761mm (45 feet) in length, about 7315mm (24 feet) in width and about 3500mm (11 feet and 5.8 inches) in overall height. As such, the cooling module unit 50 is very similar in overall dimensions to the back-to-back pair of unit structures 12 shown in Figure 4, which again facilitates shipping in a standardized shipping container.

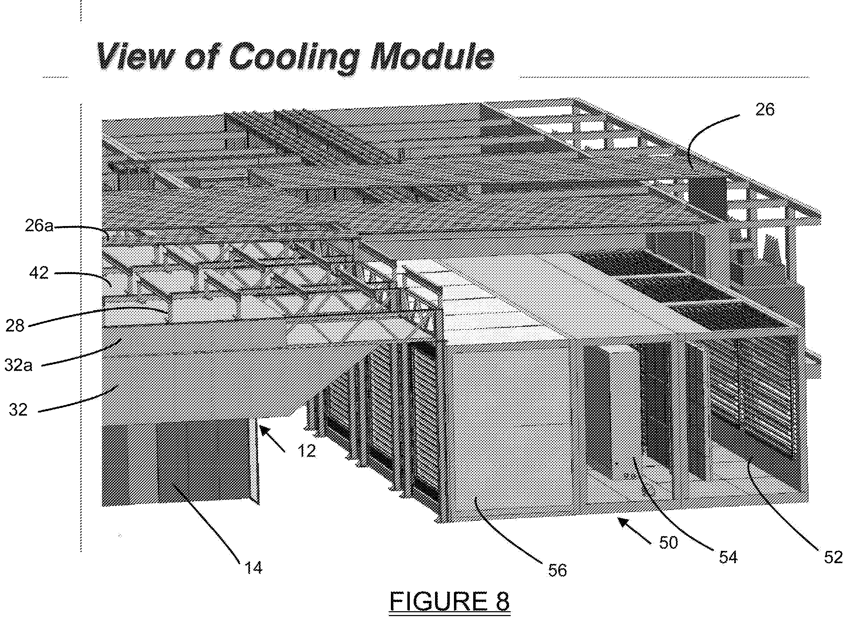

In Figure 8 one modular cooling unit 50 can be seen arranged so that its major length extends perpendicular to the major length of the unit structures 12, and such that it is positioned adjacent one of the ends of the unit structures 12. This enables the modular cooling unit 50 to supply cold air to the cold aisles 15 formed by a plurality of the unit structures 12.

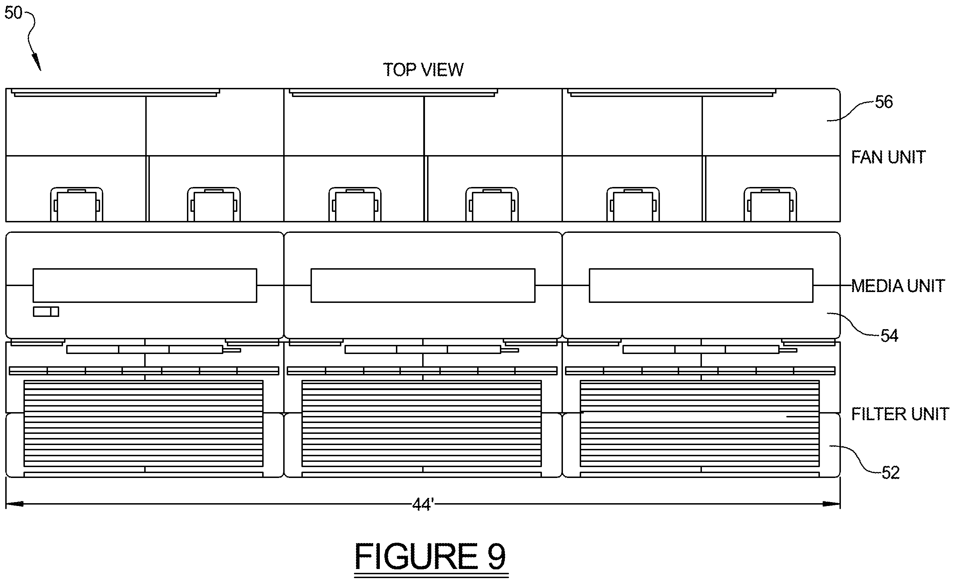

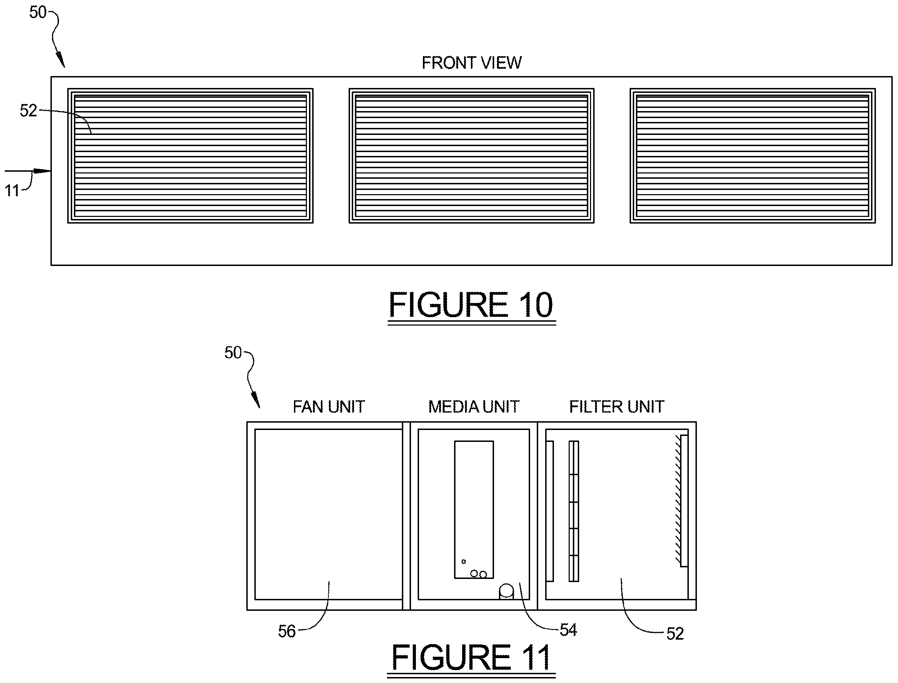

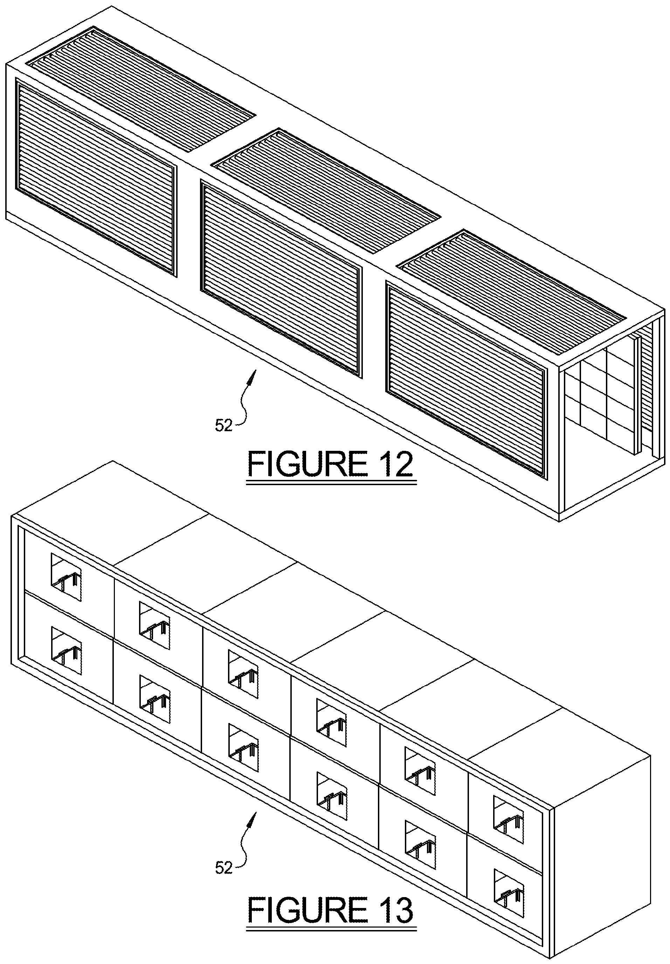

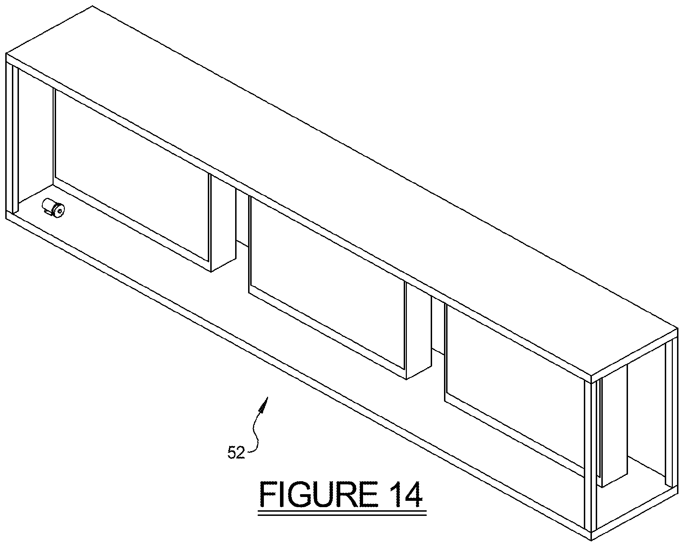

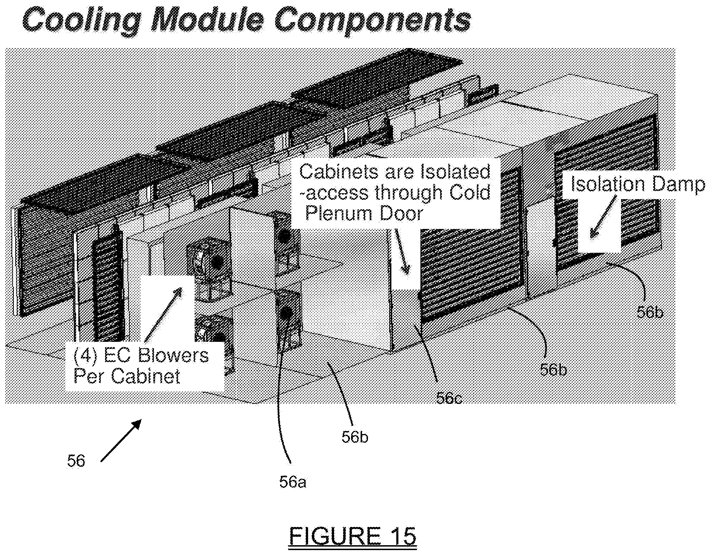

With reference to Figures 9-11, each modular cooling unit 50, in one embodiment, may form an evaporative (i.e., adiabatic) cooling unit that includes a filter unit 52, a media unit 54, a fan unit 56, and may draw on the order of 900kW. Figures 12-14 further illustrate these components. Each fan unit 56 may include a plurality of fans 56a, and in one embodiment a total of twelve such fans 56a configured in three separate cabinets 56b as shown in Figure 15. Figure 15 further illustrates that the cabinets 56b each may have an isolated access through a door 56c.

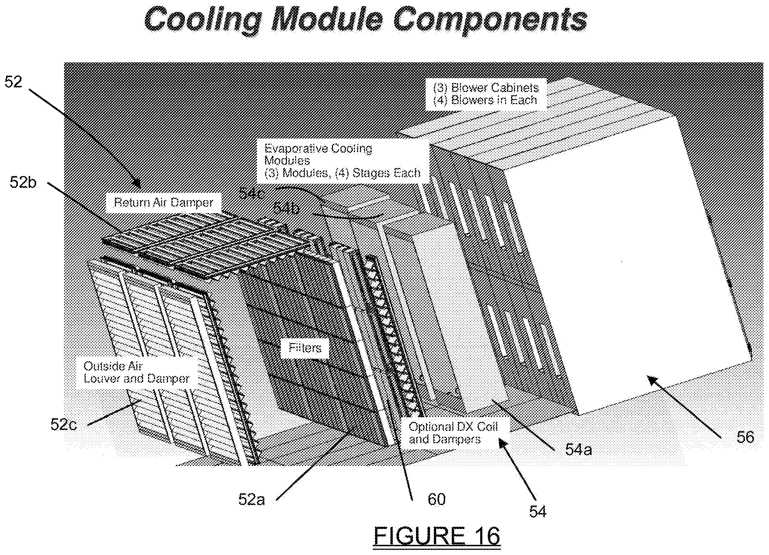

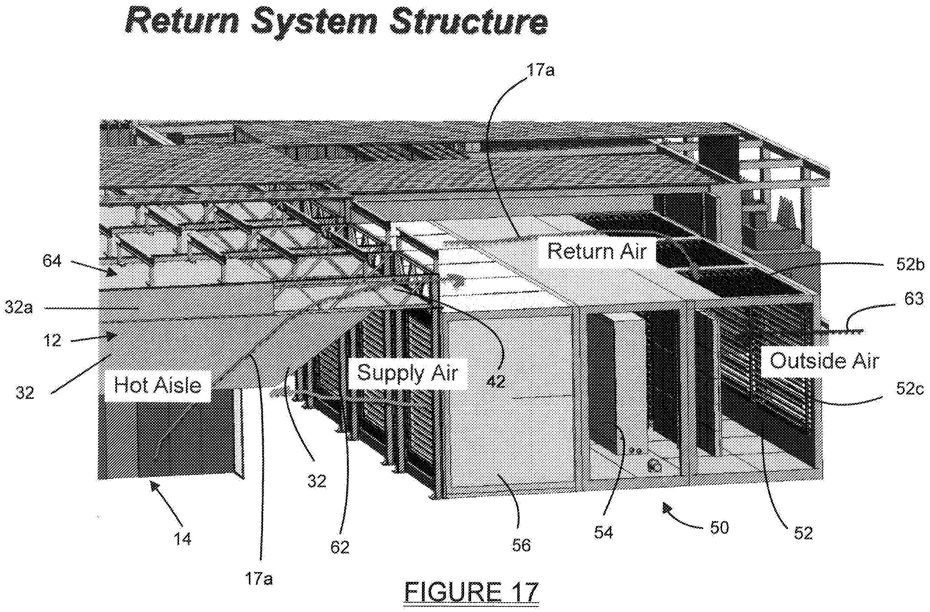

Figure 16 illustrates that the media unit 54 may include three independent evaporative cooling modules 54a-54c having four cooling stages each. A DX coil and dampers 60 may optionally be included. The filter unit 52 may include a plurality of filters 52a, an electronically actuated return air damper 52b for controlling a return air flow into the modular cooling unit 50, and an electronically actuated outside air louver and damper 52c for controlling the flow of outside (ambient air) drawn into the cooling unit 50. Figure 17 illustrates how hot air 17a in the hot air isles 17 may be returned within an area 64 formed between the ceiling panels 26, the bridging ceiling panels 26a, and the roof panels 42 of the unit structures 12 as "return" air through the return air dampers 52b to the modular cooling unit 50. Cool air 62 is supplied into each of the cold aisles 15 by the modular cooling units 50, which are able to draw in outside air 63.

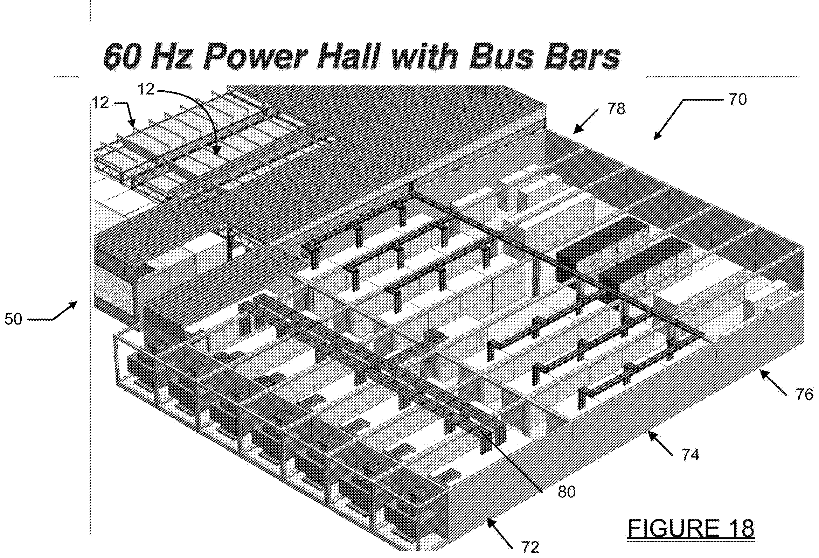

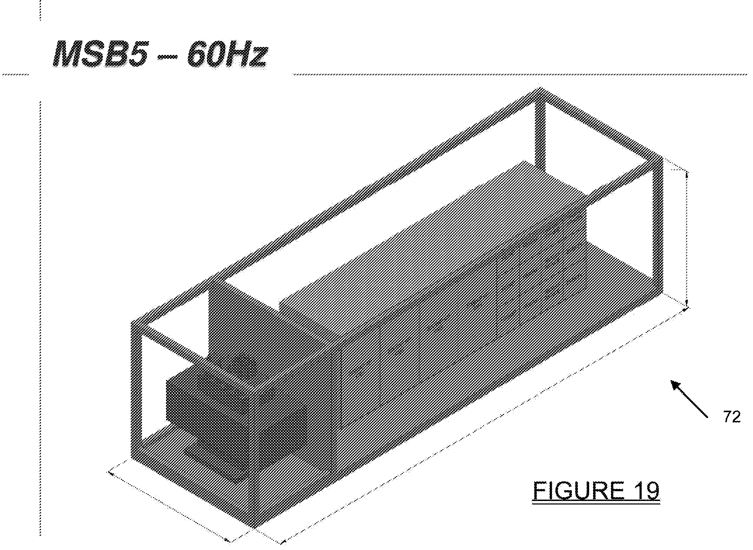

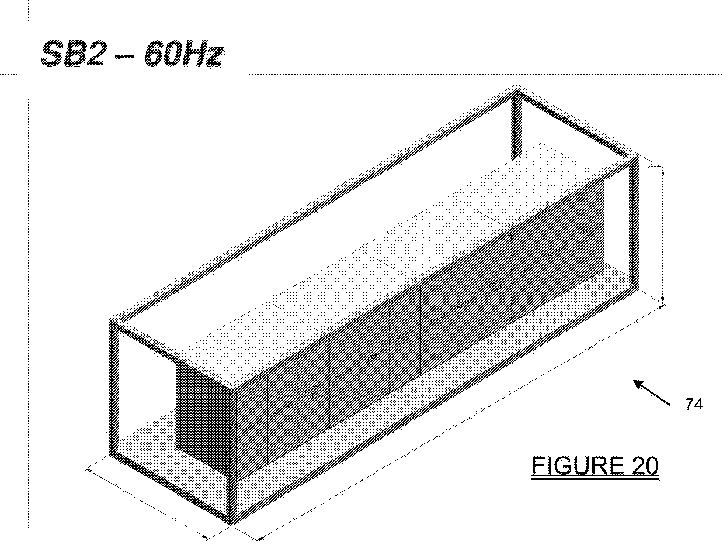

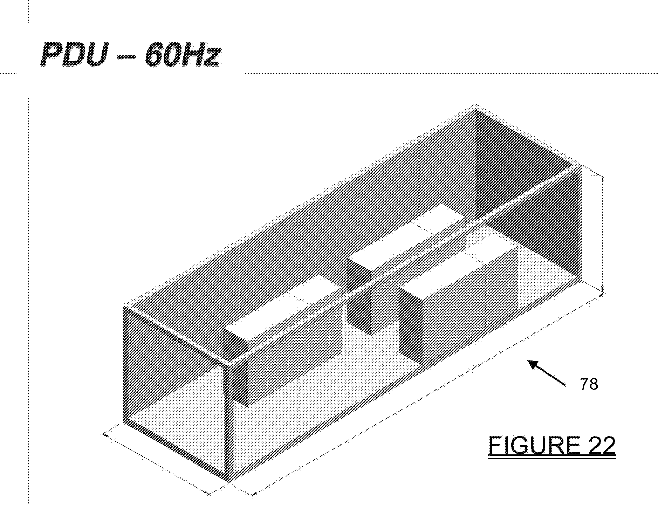

Figure 18 illustrates one embodiment of a modular "power hall" 70 that may be used in connection with the unit structures 12 to form the modular data center facility 10. With additional reference to Figures 19-22, the modular power hall 70 may be made up of one or more modular power supply units 72 (Figure 19), one or more modular power cabinet units 74 (Figure 20), one or more modular UPS (uninterruptible power supply) units 76 and one or more modular PDU (power distribution unit) units 78, as well as any other type of power component or subsystem. Figure 18 also shows a plurality of electrical bus bars 80 that may be used to connect the various components in each of the modular units 72-78 as needed to distribute power.

The modular power supply units 72 may each include a main bus, for example a 5000A main bus for supplying 100kA at 480V. A plurality of main breakers and distributed breakers may also be included along with a suitable power control system and a power quality meter.

The modular power cabinet units 74 may each include a 1600A bus main bus for delivering 65kA at 480V. Power breakers and distribution breakers may be configured as needed for specific applications.

The modular UPS units 76 may each include parallel 400kVA/400kW modules to provide 750kW of backup power. However, it will be appreciated that the UPS units 76 may be configured as needed to suit a specific application.

Each of the modular PDU units 78 may be configured to provide 300kVA 480/208/120V, or a different selected electrical output. Load distribution breakers may also be mounted in cabinets (not shown) that are in turn mounted to the sides of a frame of each PDU contained in the modular PDU unit 78.

Each of the modular units 72-78 may have similar or identical dimensions. In one embodiment the dimensions of the modular units 72-78 are identical with a length of 12192mm (40 feet), a width of 3658mm (12 feet) and a height of 3500mm (11 feet and 5.8 inches). Obviously these dimensions may be varied slightly if needed. In this example, the modular units 72-78 may have length and width dimensions that are the same as the unit structures 12. These dimensions enable shipping of the modular units 72-78 in conventional shipping containers.

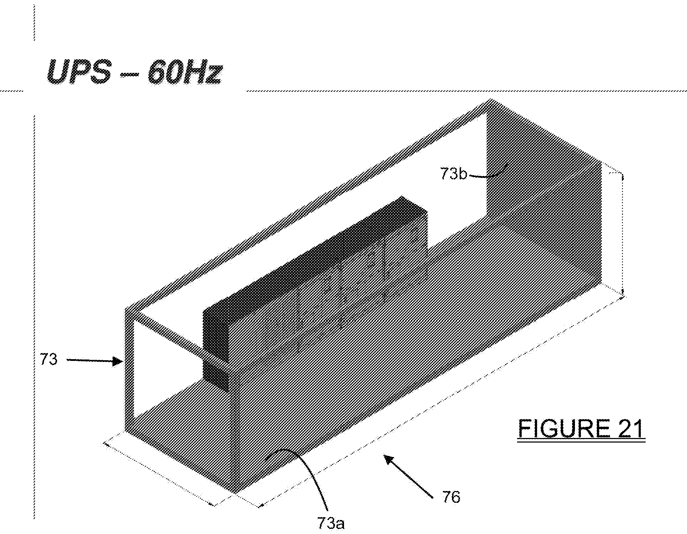

With brief reference to Figure 21, each of the modular units 72-78 may include a frame structure 73 having one or more of components secured thereto such as a floor 73a and one or more wall portions 73b. The modular units 72-78 are also rapidly deployable when they are received at the destination site. The modular configuration of the units 72-78 allows for easily expanding the power supply capabilities of the power hall 70 as data center needs grow.

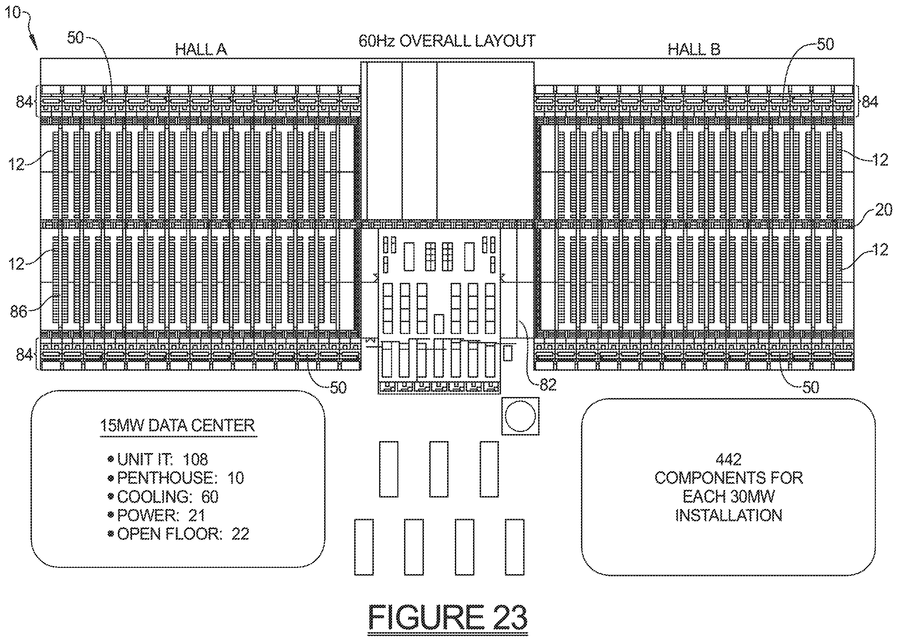

Figure 23 shows an overhead view of one example of an implementation of the modular data center facility 10. The unit structures 12 are grouped into two halls, "Hall A" and "Hall B", separated by a modular office/storage section area 80. A modular water treatment section 82 may include water treatment equipment. Rows 84 of modular cooling units 50 may be arranged adjacent the rows of unit structures 12. A row of modular penthouse exhaust structures 20 (not shown in Figure 23) may extend over a hallway area 86, perpendicularly to the unit structures 12, to interface with the hot aisles 17 adjacent the unit structures 12. A modular room 86 may be included for other data center or office equipment.

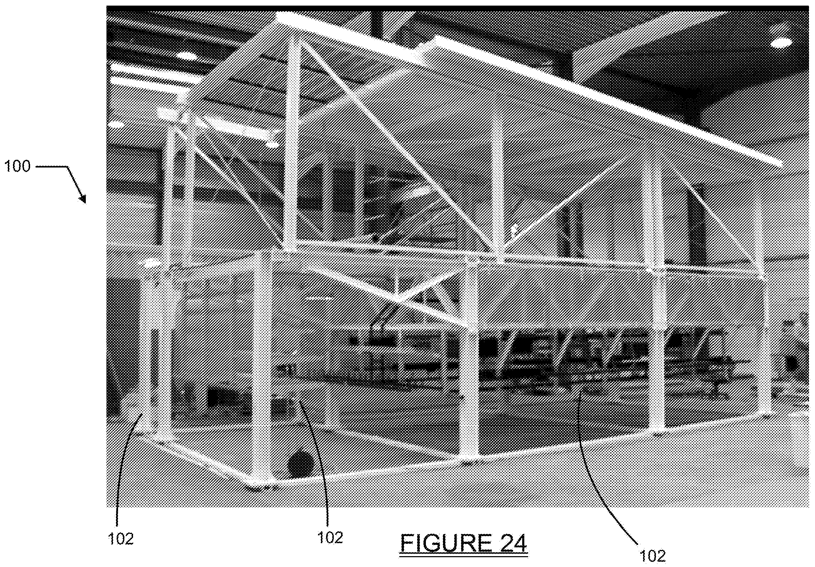

Referring to Figure 24, a unit structure 100 is shown in accordance with another embodiment of the present disclosure. The unit structure 100 is this example also has additional structural columns 102 that may be used to help form a hot aisle with one or more doors at opposing ends of the unit structure 100.

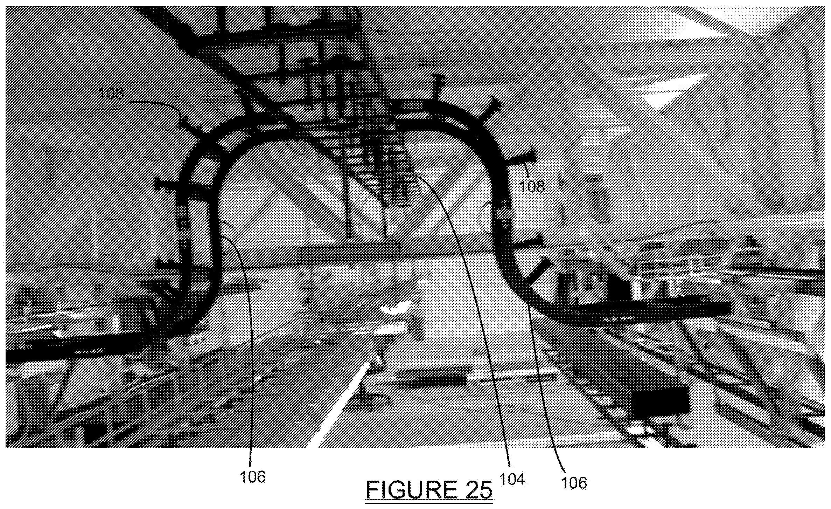

The unit structure 100 can also be seen in Figure 25 to include a central, elongated tray 104 that runs a substantial portion of a full length of the unit structure 100. The central, elongated tray 104 may include a pair of curving tray portions 106 that enable cables to be fed out from the central, elongated tray 104. The central, elongated tray 104 and the curving tray portions 106 may each include a plurality of posts 108 to help retain cables within the trays 104 and 106.

It will be appreciated that the various embodiments of the present disclosure may incorporate built in lighting fixtures, as well as one or more lengths of built in conduit for the delivery of water or a different fire suppression agent. The cable trays 38, 40 and 104 may be used to divide and route specific types of cabling (i.e., optical, power, network, etc.) depending on user requirements or preferences.

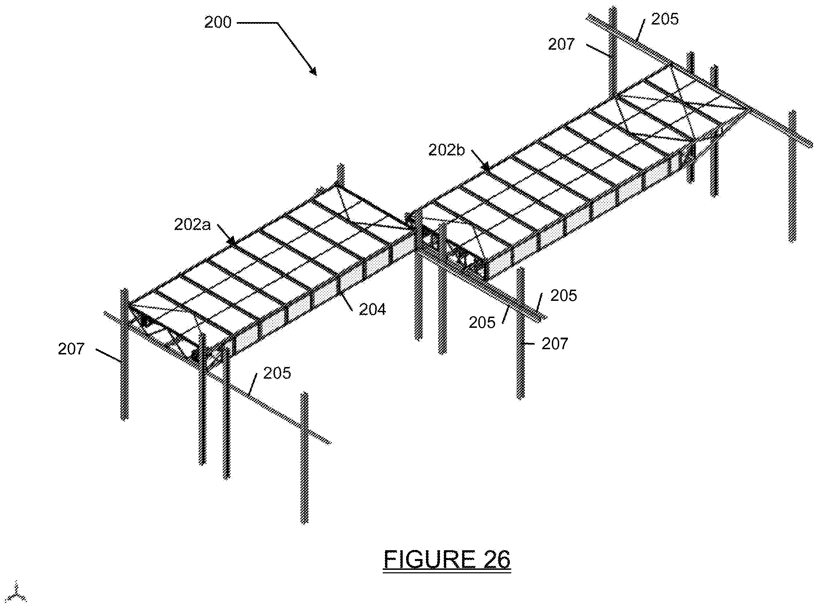

Referring to Figure 26, a modular data center system 200 is shown in simplified form. The system 200 may be modularly expanded as described with the system 10 of Figure 1 to form a data center of virtually any dimensions. The system 200 is similar to the system 10, but in Figure 26 only two unit structures 202a and 202b are shown. The unit structures 202a/202b are similar to unit structures 12, and each unit structure 202a/202b includes a perimeter frame structure 204. With a typical modern day data center, dozens or even hundreds or more unit structures 202a/202b may be employed in an X-Y grid of rows and columns to form a large, modular data center, as more typically shown in Figures 18 and 23.

The unit structures 202a/202b are supported on horizontally arranged elongated support rails 205. The support rails 205 are supported above a floor surface by support columns 207. The support rails 205 and support columns 207 are fixedly interconnected to form a rigid supporting structure having sufficient strength to support the unit structures 202a/202b at a desired height above the floor surface. The support rails 205 may have any suitable cross sectional shape, but in this example are preferably of an L-shape when viewed in cross section. An L-shape is especially works especially well to provide structural strength while allowing rolling movement of the unit structures 202a/202b thereon.

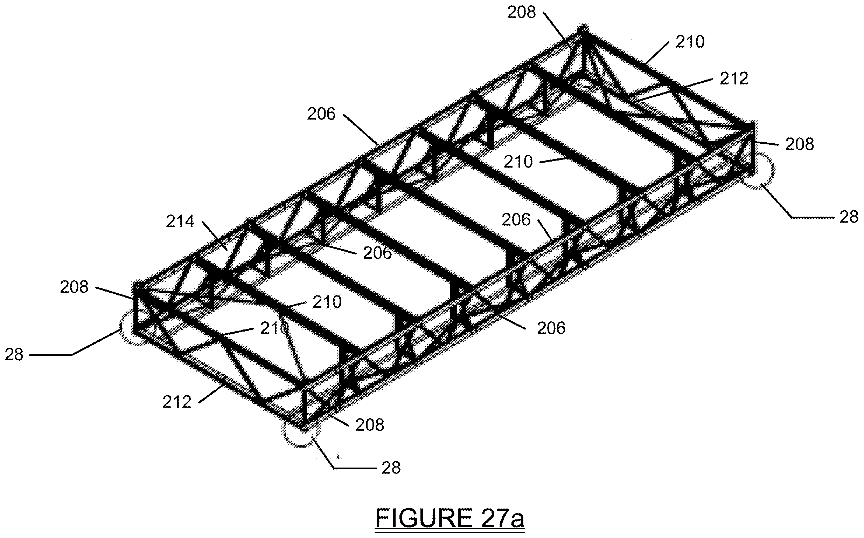

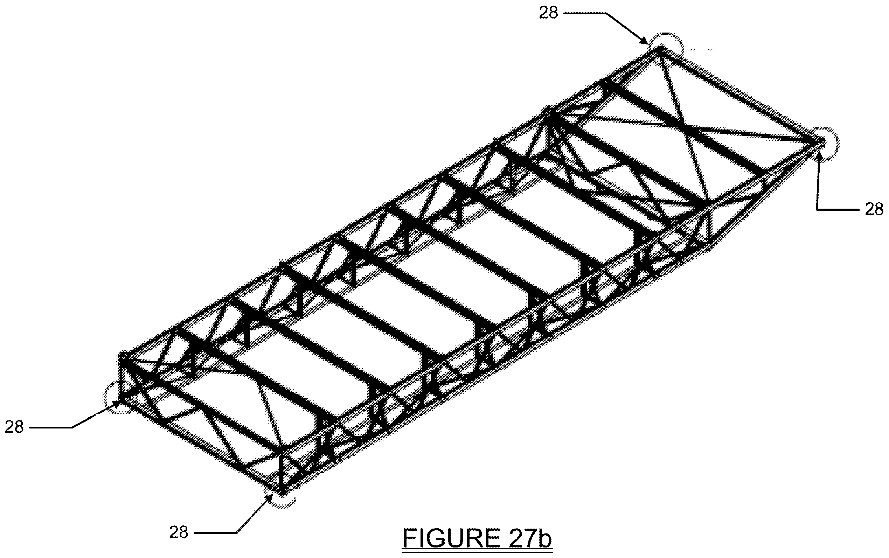

Referring to Figure 27a, the perimeter frame structure 204 of unit structure 202a is shown in greater detail. The unit structures 202a and 202b are similar in physical construction so only unit structure 202a will be described in detail. Unit structure 202a includes a plurality of frame rails 206, which may be of a square or rectangular cross sectional shape, which are all disposed parallel to one another. A plurality of frame elements 208 is disposed perpendicular to the frame rails 206 and located at the four corners of the unit structure 202a. A plurality of frame cross members 210 are disposed at each end of the unit structure 202a, and one inverted U-shaped frame track 212 is disposed at each end of the unit structure 202a. A plurality of cross bracing members 214 may also be incorporated for additional structural strength and rigidity. The components 206-214 may be fixedly interconnected such as by welding or possibly by threaded nut and bolt construction to form a highly rigid frame structure. With brief reference to Figure 27b, the carriage assemblies 216 are similarly positioned at each of the four corners of the perimeter frame structure 204 of the unit structure 202b.

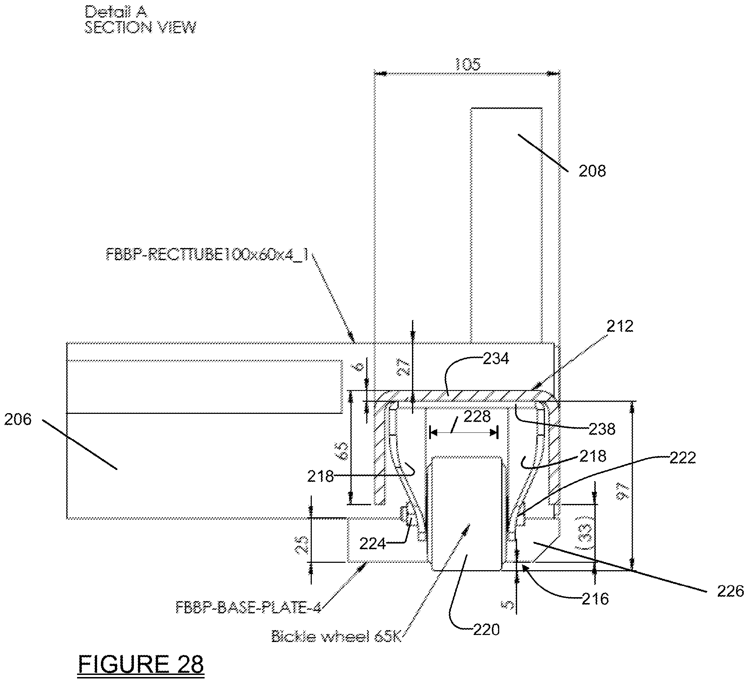

Referring to Figure 28, the areas indicated by circled areas 28 in Figure 27 are shown in greater detail in the partial cross sectional illustration of Figure 28. At each of the four corners of the unit structure 202a is a carriage assembly 216. The carriage assembly 216 includes an inverted, U-shaped wheel mounting bracket 218, a wheel 220 supported on a suitable bearing (not shown), a threaded bolt 222 and a nut 224. In this view a base plate 226 is also shown which limits rolling movement of the wheel 220 in one direction, and which will be described further in the following paragraphs. A portion of the frame rail 206 may be notched out to receive the inverted U-shaped frame track 212 perpendicularly to the frame rail 206.

The wheel 220 may be made from steel or a polymer material suitable for supporting the weight of the unit structure 202a while still allowing relatively easy rolling movement of the unit structure. Wheels suitable for this purpose are commercially available from various manufacturers, for example Blickle U.S.A. Wheels and Casters, Inc. of Charlotte, NC. The diameter of the wheel may vary considerably. The thickness of the wheel, as indicated by dimension arrow 228, in one example may be about 40mm.

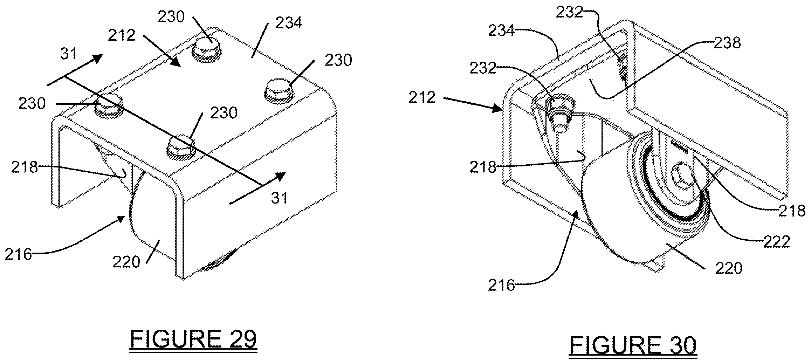

Referring to Figures 29 and 30, the attachment of the inverted U-shaped wheel mounting bracket 218 to a portion of the inverted U-shaped frame track 212 is shown. In this example a plurality of threaded bolts 230 are used along with threaded nuts 232. The threaded bolts extend through holes (not visible) in an upper surface 234 in the inverted U-shaped frame track 212.

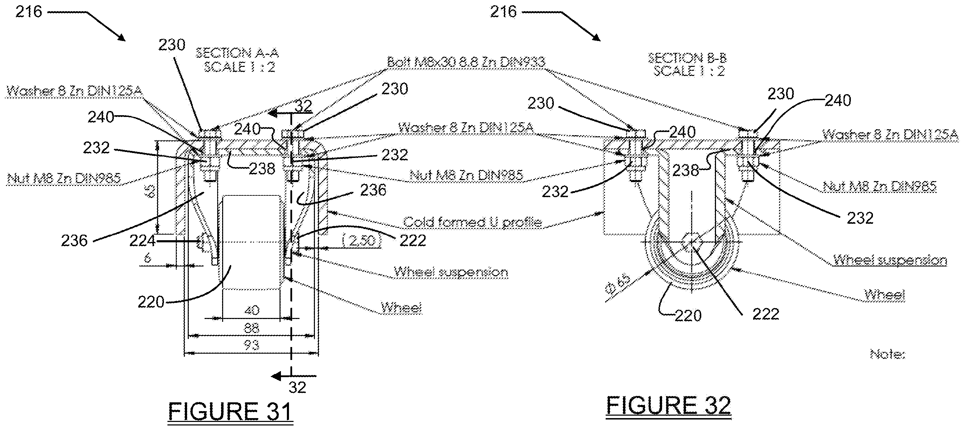

Figures 31 and 32 show the carriage assembly 216, and particularly the inverted U-shaped wheel mounting bracket 218, in greater detail. The inverted U-shaped wheel mounting bracket 218 includes sidewall portions 236 which flare outwardly slightly, and an upper wall 238. The upper wall 238 includes holes 240 through which the threaded bolts 230 extend. The threaded bolts 230 have a length sufficient to enable the threaded nuts 232 to be attached thereto but not so long as to interfere with rolling movement of the wheel 220.

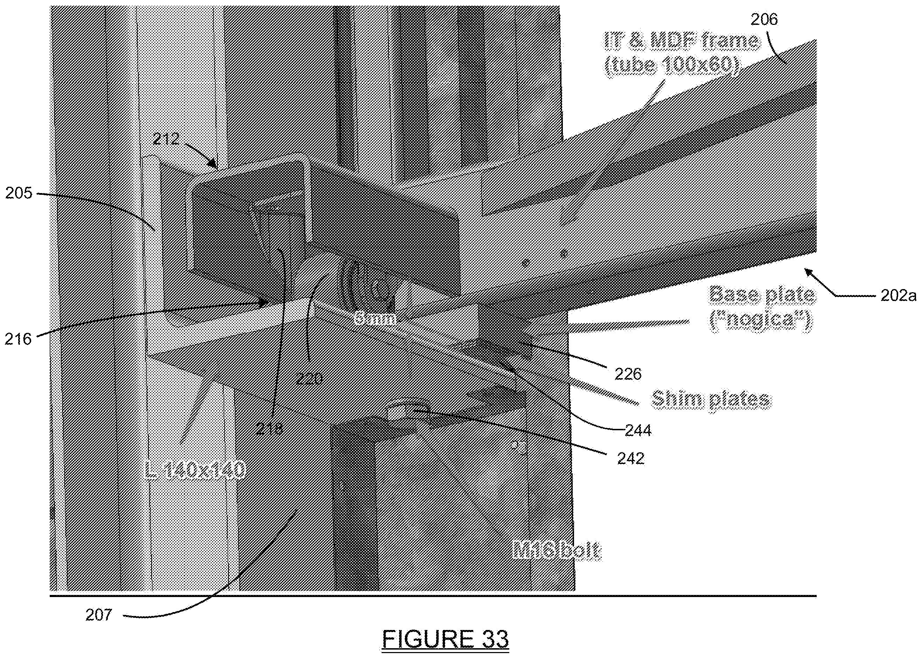

Figure 33 shows one of the carriage assemblies 216 positioned on the support rail 205. The base plate 226 for stopping rolling movement of the wheel 220 on the support rail 205 is also shown. The base plate 226 may be a metallic or high strength plastic block of material that is secured via a threaded nut 242. One or more metallic or plastic shim plates 244 may be used to adjust a height at which the base plate 216 sits to help provide a positive stopping action while still allowing clearance for the frame rail 206 of the unit structure 202a. It will be appreciated that the dimensions of the support rails 205, as well as the lateral spacing of each pair of the support rails 205, are selected to allow unimpeded movement of the inverted U-shaped frame track 212 along the support rails 205 while the unit structure 202a is being rolled into a desired position.

The modular data system 200 thus enables a plurality of unit structures 200 to be rolled into place on the support rails 205 using a suitable winch. This significantly expedites assembly of a modular data center. Since the unit structures 202a/202b may be loaded at one end of the support rails 205 and then rolled along the support rails 205 to their final designated positions, there is no need to individually assembly the unit structures themselves at the work site.

The various embodiments of the modular data center facility 10 and the system 200 enable the various modular components that are used to form the data center to be easily shipped to a destination site and constructed in a desired configuration. The modular components the data center facility 10 can be rapidly deployed so that a fully functioning data center can be constructed much more quickly than a conventional "stick built" data center structure.

## Claims

1. A modular data center system (200), comprising:
a plurality of unit structures (202a/202b) for channeling at least one of cold air or hot air from data center components located within the modular data center system when the modular data center system is fully assembled;
a plurality of structural support columns (207) for supporting the plurality of unit structures above a floor surface at a desired height relative to the floor surface;
a pair of elongated support rails (205), coupled perpendicularly to the plurality of structural support columns at approximately the desired height, to form two parallel, horizontal, spaced apart tracks;
each of the unit structures including a plurality of carriage assemblies (216), each of the carriage assemblies including a wheel (220); and
wherein the wheels of the carriage assemblies allow the unit structures to be rolled horizontally into a desired position on the pair of elongated support rails when constructing a modular data center building to expedite assembly of the modular data center building.

2. The modular data center system of claim 1, wherein each one of said pair of elongated frame rails comprises an elongated L-shaped support rail (205).

3. The modular data center system of claim 1, wherein each said unit structure includes a frame track (212) for providing structural rigidity to its associated said unit structure and forming an integral portion of its associated said unit structure.

4. The modular data center system of claim 3, wherein each said carriage assembly includes:
one said wheel operatively secured to the frame track, the wheel configured to ride on an associated one of the pair of elongated support rails to enable rolling movement of its associated said unit structure while supporting the frame track above its associated said elongated support rail.

5. The modular data center system of claim 3, wherein the frame track comprises a generally inverted U-shaped frame track (212).

6. The modular data center system of claim 5, wherein each said carriage assembly further comprise an inverted U-shaped wheel mounting bracket (218) for mounting its associated said wheel to the inverted U-shaped frame track.

7. The modular data center system of claim 1, further comprising at least one base plate (226) secured to one of the elongated support rails for limiting rolling movement of at least one said wheel of at least one said carriage assembly along an associated one of the elongated support rails.

8. The modular data center system of 1, wherein each one of the unit structures includes four of the carriage assemblies.

9. The modular data center system of claim 1, wherein each said carriage assembly is configured such that the wheels of the carriage assembly are positioned adjacent each one of four corners of the unit structure.

10. The system of claim 9, wherein each one of the elongated support rails comprises an L-shaped rail (205).

11. The system of claim 9, wherein each of the unit structures includes a pair of frame tracks (212) which form an integrated, structural portion of each of the unit structures.

12. The system of claim 11, wherein each of the frame tracks comprises an inverted U-shaped frame track (212).

13. The system of claim 11, wherein each said carriage assembly comprises:
one of the wheels which is operatively secured to an associated one of the frame tracks, the wheel configured to ride on an associated one of the pair of elongated support rails to enable rolling movement of its associated said unit structure while supporting said support track above its associated said elongated support rail;
wherein the frame tracks of the unit structures are arranged parallel to one another; and
wherein the carriage assemblies support the wheels adjacent four corners of the each of the unit structures.

14. The system of claim 9, wherein each of the carriage assemblies further comprise an inverted U-shaped wheel mounting bracket, each one of the wheel mounting brackets being operatively coupled to an associated one of the elongated support rails and operating to support its associated said wheel for rolling movement.

15. The system of claim 14, wherein first and second pairs of the wheel mounting brackets are disposed at opposite longitudinal ends of the support tracks.

16. The system of claim 15, further comprising at least one base plate fixedly secured to one of the elongated support rails for limiting rolling movement of the wheels of the carriage assemblies.

17. A method for forming a modular data center (200), the method comprising:
providing a plurality of unit structures (202a/202b) for channeling at least one of cold air or hot air from data center components located within the modular data center when the modular data center is fully assembled;
using a plurality of first structural support columns (207) for supporting the plurality of unit structures above a floor surface at a desired height relative to the floor surface;
using a pair of elongated support rails (205), coupled perpendicularly to the plurality of first structural support columns at approximately the desired height, to form two parallel, horizontal, spaced apart tracks;
using a plurality of carriage assemblies (216), each of the carriage assemblies including a wheel (220), to support each of the unit structures on the elongated support rails; and
using the wheels of the carriage assemblies to horizontally roll each of the unit structures along the elongated support rails into a desired position on the pair of elongated support rails when constructing the modular data center.

18. The method of claim 17, wherein the operation of using a plurality of carriage assemblies comprises using four carriage assemblies for each unit structure.

19. The method of claim 18, wherein the operation of using a plurality of carriage assemblies comprises using a separate wheel with each one of the carriage assemblies, with each of the wheels rolling on an associated one of the elongated support rails.

20. The method of claim 19, further comprising securing a base plate (226) to one of the elongated support rails to stop rolling movement of one of the unit structures.

## Patentansprüche

1. Modulares Datenzentrumssystem (200), das Folgendes umfasst:
mehrere Einheitsstrukturen (202a/202b) zum Kanalisieren von zumindest einer aus kalter Luft oder heißer Luft von Datenzentrumskomponenten, befindlich innerhalb des Datenzentrumssystems, wenn das modulare Datenzentrumssystem vollständig zusammengebaut ist;
mehrere strukturelle Stützsäulen (207) zum Stützen der mehreren Einheitsstrukturen über einer Bodenoberfläche bei einer gewünschten Höhe relativ zur Bodenoberfläche;
ein Paar länglicher Stützschienen (205), senkrecht gekoppelt mit den mehreren strukturellen Stützsäulen bei ungefähr der gewünschten Höhe, um zwei parallele, horizontale, voneinander beabstandete Schienen zu bilden;
wobei jede der Einheitsstrukturen mehrere Schlittenanordnungen (216) umfasst, wobei jede der Schlittenanordnungen ein Rad (220) umfasst; und
wobei die Räder der Schlittenanordnungen den Einheitsstrukturen ermöglichen, beim Bauen eines modularen Datenzentrumsgebäudes horizontal in eine gewünschte Position am Paar länglicher Stützschienen gerollt zu werden, um den Zusammenbau des modularen Datenzentrumsgebäudes zu beschleunigen.

2. Modulares Datenzentrumssystem nach Anspruch 1, wobei jede aus dem Paar länglicher Rahmenschienen eine längliche L-förmige Stützschiene (205) umfasst.

3. Modulares Datenzentrumssystem nach Anspruch 1, wobei jede solche Einheitsstruktur eine Rahmenschiene (212) zum Bereitstellen von struktureller Steifigkeit für ihre zugehörige Einheitsstruktur umfasst und die einen integralen Teil ihrer zugehörigen Einheitsstruktur bildet.

4. Modulares Datenzentrumssystem nach Anspruch 3, wobei jede Schlittenanordnung Folgendes umfasst:
ein Rad, das operativ an der Rahmenschiene gesichert ist, wobei das Rad dazu ausgelegt ist, auf einer zugehörigen aus dem Paar länglicher Stützschienen zu laufen, um rollende Bewegung seiner zugehörigen Einheitsstruktur zu ermöglichen, dabei die Rahmenschiene über ihrer zugehörigen länglichen Stützschiene stützend.

5. Modulares Datenzentrumssystem nach Anspruch 3, wobei die Rahmenschiene eine allgemein umgekehrte U-förmige Rahmenschiene (212) umfasst.

6. Modulares Datenzentrumssystem nach Anspruch 5, wobei jede der Schlittenanordnungen ferner eine umgekehrte U-förmige Radbefestigungshalterung (218) zum Montieren ihres zugehörigen Rades an der umgekehrten U-förmigen Rahmenschiene hat.

7. Modulares Datenzentrumssystem nach Anspruch 1, ferner umfassend zumindest eine Basisplatte (226), gesichert an einer der länglichen Stützschienen zum Begrenzen der rollenden Bewegung des zumindest einen Rades der zumindest einen Schlittenanordnung entlang einer zugehörigen der länglichen Stützschienen.

8. Modulares Datenzentrumssystem 1, wobei jede der Einheitsstrukturen vier der Schlittenanordnungen umfasst.

9. Modulares Datenzentrumssystem 1, wobei jede der Schlittenanordnungen so ausgelegt ist, dass die Räder der Schlittenanordnung angrenzend an die jeweiligen Ecken der Einheitsstruktur positioniert sind.

10. System nach Anspruch 9, wobei jede der länglichen Stützschienen eine L-förmige Schiene (205) umfasst.

11. System nach Anspruch 9, wobei jede der Einheitsstrukturen ein Paar Rahmenschienen (212) umfasst, die einen integrierten, strukturellen Teil der Einheitsstrukturen bilden.

12. System nach Anspruch 11, wobei jede der Rahmenschienen eine umgekehrte U-förmige Rahmenschiene (212) umfasst.

13. System nach Anspruch 11, wobei jede Schlittenanordnung Folgendes umfasst:
eines der Räder, das operativ an einer zugehörigen der Rahmenschienen gesichert ist, wobei das Rad dazu ausgelegt ist, auf einer zugehörigen aus dem Paar länglicher Stützschienen zu laufen, um rollende Bewegung seiner zugehörigen Einheitsstruktur zu ermöglichen, dabei die Stützschiene über ihrer zugehörigen länglichen Stützschiene stützend;
wobei die Rahmenschienen der Einheitsstrukturen parallel zueinander angeordnet sind; und
wobei die Schlittenanordnungen die Räder angrenzend an die vier Ecken jeder der Einheitsstrukturen stützen.

14. System nach Anspruch 9, wobei jede der Schlittenanordnungen ferner eine umgekehrte U-förmige Radbefestigungshalterung umfasst, jede der Radbefestigungshalterungen mit einer zugehörigen der länglichen Stützschienen wirkgekoppelt ist und wirkt, um ihr zugehöriges Rad für rollende Bewegung zu stützen.

15. System nach Anspruch 14, wobei erste und zweite Paare der Radbefestigungshalterungen an einander gegenüberliegenden Längsenden der Stützschienen angeordnet sind.

16. System nach Anspruch 15, ferner umfassend zumindest eine Basisplatte, die fest an einer der länglichen Stützschienen befestigt ist zum Begrenzen der rollenden Bewegung der Räder der Schlittenanordnungen.

17. Verfahren zum Bilden eines modularen Datenzentrums (200), wobei das Verfahren Folgendes umfasst:
Bereitstellen von mehreren Einheitsstrukturen (202a/202b) zum Kanalisieren von zumindest einer aus kalter Luft oder heißer Luft von Datenzentrumskomponenten, befindlich innerhalb des Datenzentrums, wenn das modulare Datenzentrum vollständig zusammengebaut ist;
Verwenden von mehreren ersten strukturellen Stützsäulen (207) zum Stützen der mehreren Einheitsstrukturen über einer Bodenoberfläche bei einer gewünschten Höhe relativ zur Bodenoberfläche;
Verwenden eines Paares länglicher Stützschienen (205), senkrecht gekoppelt mit den mehreren ersten strukturellen Stützsäulen bei ungefähr der gewünschten Höhe, um zwei parallele, horizontale, voneinander beabstandete Schienen zu bilden;
Verwenden von mehreren Schlittenanordnungen (216), wobei jede der Schlittenanordnungen ein Rad (220) umfasst, um jede der Einheitsstrukturen an den länglichen Stützschienen zu stützen; und
Verwenden der Räder der Schlittenanordnungen zum horizontalen Rollen jeder der Einheitsstrukturen entlang der länglichen Stützschienen in eine gewünschte Position an dem Paar länglicher Stützschienen beim Bauen des modularen Datenzentrums.

18. Verfahren nach Anspruch 17, wobei der Vorgang des Verwendens von mehreren Schlittenanordnungen Verwenden von vier Schlittenanordnungen für jede Einheitsstruktur umfasst.

19. Verfahren nach Anspruch 18, wobei der Vorgang des Verwendens von mehreren Schlittenanordnungen Verwenden eines separaten Rades mit jeder der Schlittenanordnungen umfasst, wobei jedes der Räder auf einer zugehörigen der länglichen Stützschienen rollt.

20. Verfahren nach Anspruch 19, ferner umfassend Sichern einer Basisplatte (226) an einer der länglichen Stützschienen zum Stoppen von rollender Bewegung einer der Einheitsstrukturen.

## Revendications

1. Système (200) de centre de données modulaire, comprenant :
une pluralité de structures unitaires (202a/202b) servant à canaliser de l'air froid et/ou de l'air chaud provenant de composants de centre de données situés à l'intérieur du système de centre de données modulaire lorsque le système de centre de données modulaire est entièrement assemblé ;
une pluralité de colonnes (207) de soutien structural servant à soutenir la pluralité de structures unitaires au-dessus d'une surface de plancher à une hauteur souhaitée par rapport à la surface de plancher ;
une paire de rails (205) de soutien allongés, couplés perpendiculairement à la pluralité de colonnes de soutien structural approximativement à la hauteur souhaitée, pour former deux glissières espacées horizontales parallèles ;
chacune des structures unitaires comprenant une pluralité d'ensembles chariots (216), chacun des ensembles chariots comprenant une roue (220) ; et
les roues des ensembles chariots permettant aux structures unitaires d'être amenées par roulement horizontal dans une position souhaitée sur la paire de rails de soutien allongés lors de la construction d'un bâtiment de centre de données modulaire pour accélérer l'assemblage du bâtiment de centre de données modulaire.

2. Système de centre de données modulaire selon la revendication 1, chaque rail de ladite paire de rails d'ossature allongés étant constitué d'un rail (205) de soutien allongé en L.

3. Système de centre de données modulaire selon la revendication 1, chacune desdites structures unitaires comprenant une glissière (212) d'ossature servant à conférer une rigidité structurale à ladite structure unitaire qui lui est associée et faisant partie intégrante de ladite structure unitaire qui lui est associée.

4. Système de centre de données modulaire selon la revendication 3, chacun desdits ensembles chariots comprenant :
une desdites roues fixée fonctionnellement à la glissière d'ossature, la roue étant configurée pour rouler sur un rail associé de la paire de rails de soutien allongés pour permettre un mouvement de roulement de ladite structure unitaire qui lui est associée tout en soutenant la glissière d'ossature au-dessus dudit rail de soutien allongé qui lui est associé.

5. Système de centre de données modulaire selon la revendication 3, la glissière d'ossature étant constituée d'une glissière (212) d'ossature présentant généralement la forme d'un U inversé.

6. Système de centre de données modulaire selon la revendication 5, chacun desdits ensembles chariots comprenant en outre un support (218) de montage de roue en forme de U inversé servant à monter ladite roue qui lui est associée sur la glissière d'ossature en forme de U inversé.

7. Système de centre de données modulaire selon la revendication 1, comprenant en outre au moins une plaque (226) de base fixée à un des rails de soutien allongés pour limiter le mouvement de roulement d'au moins une desdites roues d'au moins un desdits ensembles chariots le long d'un rail associé parmi les rails de soutien allongés.

8. Système de centre de données modulaire selon la revendication 1, chacune des structures unitaires comprenant quatre des ensembles chariots.

9. Système de centre de données modulaire selon la revendication 1, chacun desdits ensembles chariots étant configuré de telle façon que les roues de l'ensemble chariot soient positionnées au voisinage de chacun des quatre coins de la structure unitaire.

10. Système selon la revendication 9, chacun des rails de soutien allongés étant constitué d'un rail (205) en L.

11. Système selon la revendication 9, chacune des structures unitaires comprenant une paire de glissières (212) d'ossature qui forment une partie structurale intégrée de chacune des structures unitaires.

12. Système selon la revendication 11, chacune des glissières d'ossature étant constituée d'une glissière (212) d'ossature en forme de U inversé.

13. Système selon la revendication 11, chacun desdits ensembles chariots comprenant :
une des roues qui est fixée fonctionnellement à une glissière associée parmi les glissières d'ossature, la roue étant configurée pour rouler sur un rail associé de la paire de rails de soutien allongés pour permettre un mouvement de roulement de ladite structure unitaire qui lui est associée tout en soutenant ladite glissière de soutien au-dessus dudit rail de soutien allongé qui lui est associé ;
les glissières d'ossature des structures unitaires étant disposées parallèlement les unes aux autres ; et
les ensembles chariots soutenant les roues au voisinage de quatre coins de chacune des structures unitaires.

14. Système selon la revendication 9, chacun des ensembles chariots comprenant en outre un support de montage de roue en forme de U inversé, chacun des supports de montage de roues étant couplé fonctionnellement à un rail associé parmi les rails de soutien allongés et fonctionnant pour soutenir ladite roue qui lui est associée en vue d'un mouvement de roulement.

15. Système selon la revendication 14, des premières et secondes paires des supports de montage de roues étant disposées à des extrémités longitudinales opposées des glissières de soutien.

16. Système selon la revendication 15, comprenant en outre au moins une plaque de base en liaison complète avec un des rails de soutien allongés pour limiter le mouvement de roulement des roues des ensembles chariots.

17. Procédé de formation d'un centre de données modulaire (200), le procédé comprenant :
la mise en place d'une pluralité de structures unitaires (202a/202b) servant à canaliser de l'air froid et/ou de l'air chaud provenant de composants de centre de données situés à l'intérieur du centre de données modulaire lorsque le centre de données modulaire est entièrement assemblé ;
l'utilisation d'une pluralité de premières colonnes (207) de soutien structural pour soutenir la pluralité de structures unitaires au-dessus d'une surface de plancher à une hauteur souhaitée par rapport à la surface de plancher ;
l'utilisation d'une paire de rails (205) de soutien allongés, couplés perpendiculairement à la pluralité de premières colonnes de soutien structural approximativement à la hauteur souhaitée, pour former deux glissières espacées horizontales parallèles ;
l'utilisation d'une pluralité d'ensembles chariots (216), chacun des ensembles chariots comprenant une roue (220), pour soutenir chacune des structures unitaires sur les rails de soutien allongés ; et
l'utilisation des roues des ensembles chariots pour amener par roulement horizontal chacune des structures unitaires, le long des rails de soutien allongés, dans une position souhaitée sur la paire de rails de soutien allongés lors de la construction du centre de données modulaire.

18. Procédé selon la revendication 17, l'opération d'utilisation d'une pluralité d'ensembles chariots comprenant l'utilisation de quatre ensembles chariots pour chaque structure unitaire.

19. Procédé selon la revendication 18, l'opération d'utilisation d'une pluralité d'ensembles chariots comprenant l'utilisation d'une roue distincte avec chacun des ensembles chariots, chacune des roues roulant sur un rail associé parmi les rails de soutien allongés.

20. Procédé selon la revendication 19, comprenant en outre la fixation d'une plaque (226) de base à un des rails de soutien allongés pour arrêter le mouvement de roulement d'une des structures unitaires.
